# EUROPÄISCHE PATENTSCHRIFT

(11) **EP 1 052 774 B1**
(45) Veröffentlichungstag und Bekanntmachung des Hinweises auf die Patenterteilung: **03.02.2010**
(21) Anmeldenummer: 00103612.8
(22) Anmeldetag: 21.02.2000
(51) Int. Cl.: H03K 17/687, H03K 17/082, H03K 17/06, H03K 17/0814

(54) **Schaltungsanordnung mit Halbbrücke**
Circuit arrangement with a half bridge
Circuit avec un démipont

(30) Priorität: 16.04.1999 DE 19917364
(43) Veröffentlichungstag der Anmeldung: 15.11.2000
(73) Patentinhaber: Osram Gesellschaft mit beschränkter Haftung, 81543 München (DE)
(72) Erfinder: Limmer, Walter, 80801 München (DE); Niedermeier, Peter, 80995 München (DE); Huber, Andreas, 82216 Maisach (DE)

(56) Entgegenhaltungen:
- EP-A- 0 758 160
- EP-A- 0 905 873
- FR-A- 2 762 705
- US-A- 3 770 986
- US-A- 4 316 243
- US-A- 5 107 151
- US-A- 5 260 607
- US-A- 5 373 435
- US-A- 5 408 150
- US-A- 5 410 466
- US-A- 5 627 743

## Beschreibung

Die vorliegende Erfindung betrifft eine Schaltungsanordnung mit einer Halbbrückenanordnung umfassend einen ersten und einen zweiten MOSFET-Schalter, wobei jeder MOSFET-Schalter zwischen seiner Arbeits- und Bezugselektrode eine zur Hauptstromflußrichtung des jeweiligen MOSFET-Schalters antiparallel geschaltete parasitäre Diode sowie eine ebenfalls zwischen Arbeits- und Bezugselektrode geschaltete parasitäre Kapazität aufweist, wobei seriell zum jeweiligen MOSFET-Schalter in Hauptstromflußrichtung eine Seriendiode derart angeordnet ist, daß ein Stromfluß in der Hauptstromflußrichtung möglich ist, und zur jeweiligen Serienschaltung aus MOSFET-Schafter und Seriendiode eine Freilaufdiode parallel geschaltet ist, und einem Lastkreis, der zumindest eine induktive Komponente aufweist und mit dem Mittelpunkt der Halbbrückenanordnung verbunden ist.

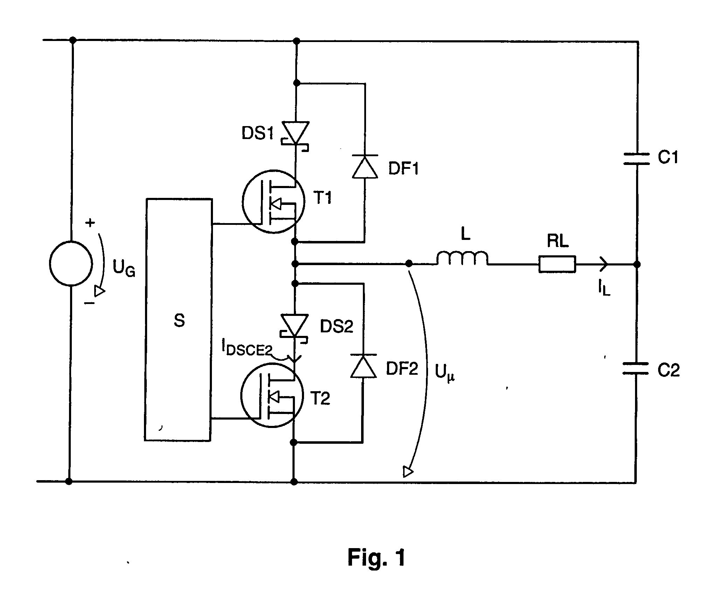

Eine derartige aus dem Stand der Technik bekannte Schaltungsanordnung ist in Figur 1 dargestellt. An ihr soll die der Erfindung zugrunde liegende Problematik dargestellt werden.

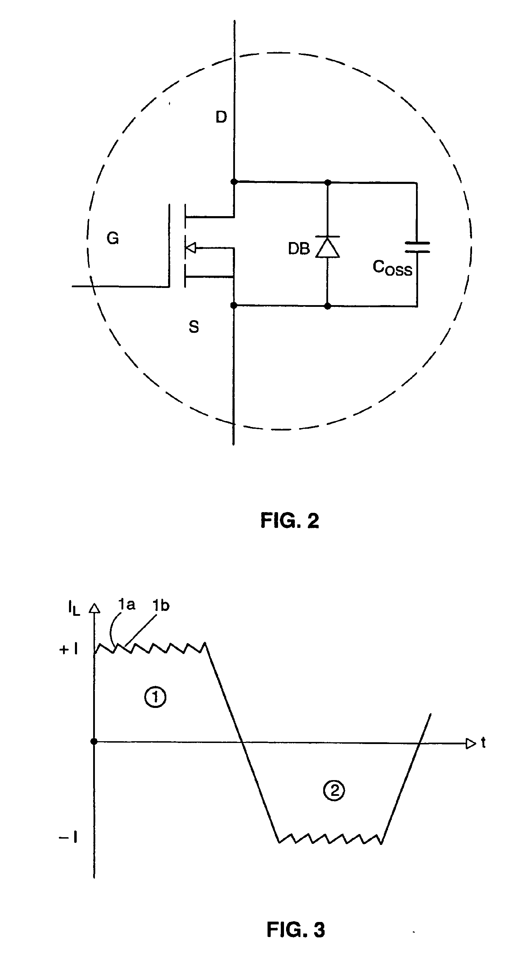

Figur 1 zeigt den im Rahmen der vorliegenden Erfindung interessierenden Teil einer Schaltungwmordnung, die in unterschiedlichsten Gebieten der Elektronik wieder zu finden ist, beispielsweise bei Tiefsetzstellern, Gleichstrommotor-Stromrichtem sowie Dreiphasenmotor-Stromrichtem etc.. Sie umfasst eine Halbbrückenanordnung mit zwei Schaltern T1 und T2, vorliegend MOSFET-Transistoren, die aus einer Gleichspannungsquelle U_{G}, beispielsweise einer Zwischenkreisspannung, gespeist werden. Um die zu der in Figur 1 dargestellten Schaltung führenden Überlegungen nachzuvollziehen, wird die in Figur 1 dargestellte Schaltung zunächst ohne die zu den Schaltern T1 und T2 seriell angeordneten Seriendioden DS1 und DS2 sowie den zu der jeweiligen Kombination aus Seriendiode und Schalter parallel geschalteten Freilaufdioden DF1 und DF2 betrachtet. Mit dem Halbbrückenmittelpunkt ist ein Lastkreis verbunden, der eine induktive Komponente aufweist, schematisch dargestellt als Serienschaltung aus Induktivität L und ohmschem Widerstand RL, die beide vom Laststrom I_{L} durchflossen werden. Der Lastkreis ist ferner verbunden mit dem Mittelpunkt zweier in Serie geschalteter Kondensatoren C1, C2, die parallel zu den Halbbrückenschaltern T1 und T2 angeordnet sind. Die Halbbrückenschalter T1 und T2 werden von einer schematisch dargestellten Steuervorrichtung S angesteuert. Figur 2 zeigt ein Ersatzschaltbild eines MOSFET, aus dem hervorgeht daß zwischen Drain und Source eine zur Hauptstromflußrichtung von Drain zur Source antiparalle so genannte Body-Diode DB und parallel hierzu eine Ausgangskapazität C_{OSS} angeordnet ist. Figur 3 zeigt den zeitlichen Verlauf des Laststroms I_{L} für eine beispielhafte Ansteuerung der Halbbrückenanordnung durch die Steuervorrichtung S. Während der Phase 1 ist der MOSFET-Transistor T2 ausgeschaltet und der MOSFET-Transistor T1 wird abwechselnd ein- und ausgeschaltet, während dies in Phase 2 umgekehrt ist. Während des vergrößert dargestellten Phasenabschnitts 1a fließt der Strom in der Masche -U_{G} T1 L RL C2, während des Phasenabschnitts 1b fließt der Laststrom nach dem Abschalten von T1, wobei T2 weiterhin ausgeschaltet bleibt aufgrund der induktiven Komponente des Lastkreises weiter in der Masche L RL C2 T2. Dies wird ermöglicht durch die Body-Diode DB des MOSFET-Schalters T2. Die dem MOSFET-Transistor T2 innewohnende Body-Diode DB ist hinsichtlich ihrer elektrischen Eigenschaften gekennzeichnet durch eine sehr langsame Abschaltzeit sowie eine niedrige Flussspannung. Wird nun T1 nach Phase 1b wieder eingeschaltet, das heißt am Halbbrückenmittelpunkt liegt die Spannung U_{µ} gleich U_{G} an, so fließt für einen kurzen Moment über die Body-Diode DB des MOSFET-Transistor T2 ein Strom, der als Kurzschlussstrom bezeichnet werden könnte, was zu einer hohen im Transistor umgesetzten Verlustleistung führt. Dies führt zu internen und externen Störungen einer derartigen Schaltungsanordnung, beispielsweise im EMV-Bereich. Näheres hierzu findet sich auch in der EP 0 905 873.

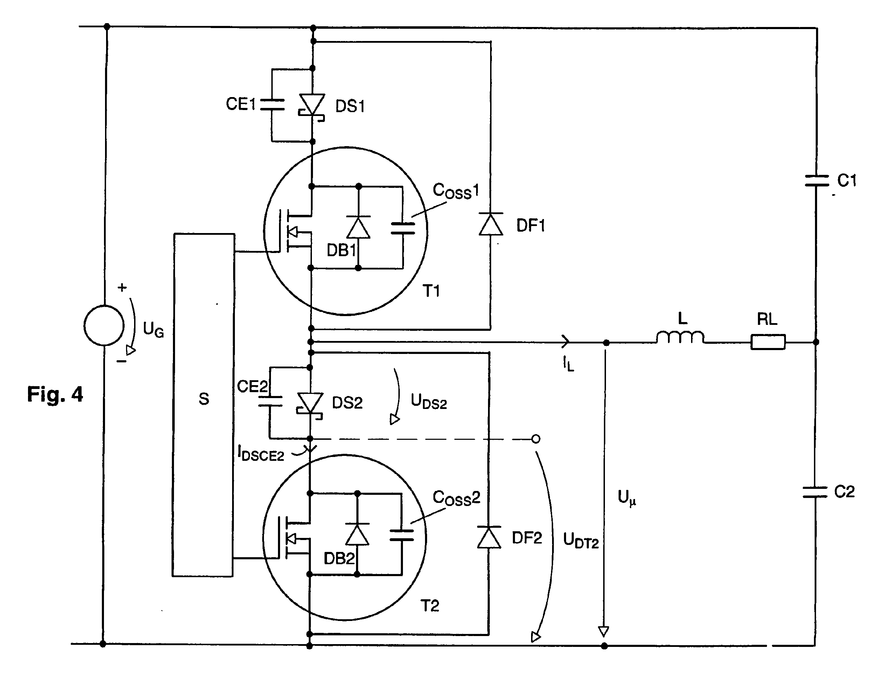

Zur Verbesserung der Zuverlässigkeit einer derartigen Schaltung sowie zur Vermeidung der Notwendigkeit von Abschirmungen, um Störungen zu unterdrücken, wurde im Stand der Technik vorgesehen, seriell zu jedem MOSFET-Schalter eine Seriendiode DS1 bzw. DS2, vorzugsweise realisiert als Schottky-Dioden, da diesen Dioden eine niedrige Flussspannung eigen ist, anzuordnen, die so orientiert sind, daß ein Stromfluß in Hauptstromflußrichtung des jeweiligen Schalters ermöglicht wird. Als Konsequenz sind daher die jeweilige Seriendiode DS1 bzw. DS2 und die dazugehörige Body-Diode DB1 bzw. DB2 (siehe hierzu auch Figur 4) antiseriell geschaltet, weshalb ein Stromfluß durch die jeweilige Body-Diode während des Freilaufens (Phase 1B von Figur 3) verhindert wird. Da demnach die Funktion der dem MOSFET innewohnenden Body-Diode durch die jeweilige Seriendiode unterbunden wird, muß eine parallel zu dieser Kombination angeordnete Freilaufdiode DF1 bzw. DF2 vorgesehen werden, die nunmehr die ursprüngliche Funktion der jeweiligen Body-Diode übernimmt.

In der Praxis hat sich jedoch nunmehr gezeigt, daß bei einer derartigen Schaltungsanordnung häufig eine der beiden Dioden DS1 oder DS2 ausfällt.

Es ist deshalb Aufgabe der vorliegenden Erfindung, eine Schaltungsanordnung der eingangs genannten Art, wie sie in Figur 1 dargestellt ist, derart zu verbessern, daß die Ausfallrate der Seriendioden DS1 bzw. DS2 reduziert wird.

Diese Aufgabe wird dadurch gelöst daß jeder Seriendiode eine Entlastungskapazität parallel geschaltet wird. Diese Maßnahme deren Funktion weiter unten detailliert erläutert wird, führt nicht nur zu einer deutlich verringerten Ausfallrate der Dioden DS1 bzw. DS2, sondern auch zu einer Reduktion der in der Schaltung umgesetzten Verlustleistung. Sie ermöglicht auch die Verwendung kleinerer und damit billigerer Dioden für die Seriendioden DS1 und DS2.

Die erfindungsgemäße Lösung ist bei Halbbrückenanordnungen anzuwenden, deren Schalter durch einen MOSFET realisiert sind, wobei, wie erwähnt, die jeweilige parasitäre Diode von der jeweiligen Body-Diode und die jeweilige parasitäre Kapazität von der jeweiligen Ausgangskapazität C_{OSS} gebildet wird.

Vorzugsweise ist jede Entlastungskapazität derart dimensioniert, daß die im Betrieb der Schaltungsanordnung an der Entlastungskapazität des jeweiligen im Wesentlichen aus Entlastungskapazität und parasitärer Kapazität gebildeten Spannungsteilers abfallende Spannung stets kleiner als die Sperrspannung der jeweiligen Seriendiode ist. Die Entlastungskapazität beträgt vorzugsweise 100 pF bis 10 nF.

Die Anwendung der Erfindung ist selbstverständlich nicht auf Halbbrückenanordnungen begrenzt, sondern kann unter Verwendung zweier weiterer MOSFET-Schalter in einer Vollbrückenanordnung realisiert sein, wobei zwischen den Mittelpunkten der MOSFET-Schalter der Lastkreis angekoppelt ist.

Auch läßt sich die erfindungsgemäße Lösung unter Ergänzung der Halbbrükkenanordnung um vier weitere MOSFET-Schalter in einer Dreiphasenbrücke realisieren, an die der Lastkreis angekoppelt ist. Insofern ergeben sich vielfältige Einsatzgebiete, wobei beispielhaft Tiefsetzsteller, wie sie in Vorschaltgeräten zum Betrieb von Entladungslampen Verwendung finden, Gleichstrommotor-Stromrichter sowie Dreiphasenmotor-Stromrichter genannt werden.

Weitere vorteilhalte Weiterbildungen der Erfindung sind in den Unteransprüchen definiert.

Ein Ausführungsbeispiel wird im Folgenden unter Hinweis auf die beigefügten Zeichnungen näher beschrieben. Es stellen dar:
- Figur 1: eine Schaltungsanordnung, die aus dem Stand der Technik be- kannt ist;
- Figur 2: ein Ersatzschaltbild für einen MOSFET;
- Figur 3: den zeitlichen Ablauf des Laststroms I_{L} bei entsprechender An- steuerung der Schaltungsanordnung gemäß Figur 1;
- Figur 4: eine Schaltungsanordnung, bei der die erfindungsgemäße Lö- sung realisiert ist;
- Figur 5: zeitliche Verläufe der Spannungen U_{µ}, U_{DT2}, U_{DS2} sowie des Stroms I_{DSCE2} der Schaltungsanordnungen gemäß Figur 1 und 4 bei entsprechender Ansteuerung.

Figur 4 zeigt eine erfindungsgemäße Schaltungsanordnung, bei der dieselben Bauteile wie in Figur 1 und in dem Ersatzschaltbild gemäß Figur 2 mit denselben Bezugszeichen bezeichnet sind. Parallel zu den Seriendioden DS1 und DS2 sind Entlastungskapazitäten CE1 und CE2 geschaltet, die für die nachfolgenden Überlegungen zunächst noch außer Betracht bleiben sollen. Aufgrund des Schaltens der MOSFET-Transistoren T1 bzw. T2 und des induktiven Teils des Lastkreises wechselt das Potential U_{µ} des Halbbrückenmittelpunkts zwischen +U_{G} und Masse hin- und her. Hierbei wirkt der jeweilige Drain-Anschluß der Transistoren T1 und T2 als Arbeits-, der jeweilige Source-Anschluß als Bezugselektrode.

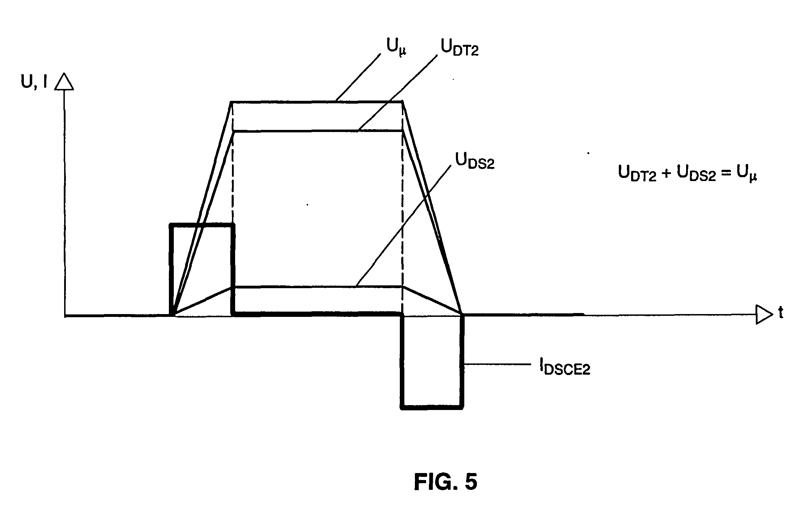

Die steilen Schaltflanken beim Übergang des Potentials U_{µ} von 0 auf U_{G} führen zu einem Ausgleichsstrom I_{DSCE2} und zur Ladung der Kapazität C_{OSS}2. Im Falle von Fig. 1 fließt der Strom I_{DSCE2} nur durch die Schottky-Diode DS2, im Falle von Fig. 4 hingegen durch die Parallelschaltung aus Diode DS2 und Entlastungskapazität CE2. Da U_{µ} in der Größenordnung von einigen Hundert Volt, ja sogar darüber liegen kann, fließt hierbei ein beträchtlicher Strom I_{DSCE2}, siehe Fig. 5. Problematischer ist jedoch der Übergang von einem Zustand, in dem U_{µ} gleich U_{G} ist, auf U_{µ} gleich 0. In diesem Fall fließt ein negativer I_{DSCE2} zur Entladung der Ausgangskapazität C_{OSS}2, das heißt im Falle von Fig. 1 wird die Diode DS2 im so genannten Avalanchebetrieb betrieben. Avalanchebetrieb bedeutet, daß an der Diode DS2 eine Spannung in Sperrichtung anliegt, die größer ist als die Sperrspannung dieser Diode, weshalb die Diode DS2 einen Stromfluß in Sperrrichtung (negativer I_{DSCE2}, siehe Fig. 5) zuläßt. Im Avalanchebetrieb fällt an der Diode die ihr eigene Sperrspannung ab.

Der Avalanchebetrieb scheint die primäre Ursache für den Ausfall der Seriendioden zu sein. Zusätzlich führt diese Betriebsweise der Seriendioden jedoch auch zum Umsatz einer Verlustleistung in diesen Dioden, nämlich des Produkts aus Sperrspannung von DS2 mal Strom I_{DSCE2}.

Die erfindungsgemäß eingefügten Entlastungskondensatoren CE1 bzw. CE2 wirken in folgender Weise: Ein negativer Strom I_{OSCE2} lädt den zur Seriendiode DS2 parallel liegenden Entlastungskondensator CE2 mit definierter Flankensteilheit. Wird der Kondensator CE2 in geeigneter Weise dimensioniert, so verhindert er, daß die Durchbruchspannung der Diode DS2 erreicht wird. Ein Avalanchebetrieb der Seriendiode DS2 findet somit nicht statt. Beim folgenden Spannungssprung von U_{µ} von Masse auf +U_{G} entlädt sich der Entlastungskondensator CE2 wieder.

Die obigen Ausführungen gelten in analoger Weise für die Seriendiode DS1 und den Entlastungskondensator CE1.

Zur Dimensionierung der jeweiligen Entlastungskapazität CE kann die jeweilige Kombination aus Seriendiode DS, Entlastungskondensator CE, Body-Diode DB und Ausgangskapazität C_{OSS} zu einer Serienschaltung aus Entlastungskondensator CE und Ausgangskapazität C_{OSS} vereinfacht werden, da sich beide Dioden im gesperrten Zustand befinden. Der aus Entlastungskondensator CE und Ausgangkapazität C_{OSS} bestehende Spannungsteiler wird dann vorteilhafterweise so dimensioniert, daß die am Entlastungskondensator CE abfallende maximale Spannung unterhalb der Sperrspannung der parallel zum Entlastungskondensator CE liegenden Seriendiode DS bleibt. Zu berücksichtigen ist hierbei die Spannungsabhängigkeit der Ausgangskapazität C_{OSS}.

Neben dem beabsichtigten Effekt, der Reduzierung der Ausfallrate der Seriendioden hat diese Maßnahme weiterhin zur Folge, daß nunmehr in den Seriendioden keine Wirkleistung mehr umgesetzt wird, sondern lediglich Blindleistungen zwischen Entlastungskondensator und Ausgangskapazität C_{OSS} hin- und hergeschoben werden. Dies führt zu einer Reduktion der Wärmeentwicklung der Schaltungsanordnung mit den damit einhergehenden Vorteilen.

Die vorliegende Schaltung wurde am Beispiel einer Halbbrückenanordnung mit n-Kanal MOSFET beschrieben, sie kann jedoch, wie für den Fachmann offensichtlich ist, auch unter Verwendung von p-Kanal MOSFET realisiert werden. Durch Ersetzen der Kondensatoren C1 und C2 durch MOSFET-Schafter kann sie ohne weiteres in einer Vollbrückenanordnung angewendet werden. Wie für den Fachmann erkennbar, läßt sie sich auch bei einem Dreiphasenmotor-Stromrichter anwenden, wobei hier vorzugsweise vier weitere MOSFET-Schalter der Halbbrückenanordnung hinzugefügt werden.

Für die Funktionsweise der Erfindung ist es gleichgültig, ob die Kombination aus Seriendiode DS und Entlastungskapazität CE arbeits- oder bezugselektrodenseitig zum zugehörigen MOSFET-Schalter geschattet ist.

## Patentansprüche

1. Schaltungsanordnung mit
- einer Halbbrückenanordnung umfassend einen ersten und einen zweiten MOSFET-Schalter (T1; T2), wobei jeder MOSFET-Schalter (T1; T2) zwischen seiner Arbeits- und Bezugselektrode eine zur Hauptstromflußrichtung des jeweiligen MOSFET-Schalters (T1; T2) antiparallel geschaltete parasitäre Diode sowie eine ebenfalls zwischen Arbeits- und Bezugselektrode geschaltete parasitäre Kapazität aufweist, seriell zum jeweiligen MOSFET-Schalter (T1; T2) in Hauptstromflußrichtung eine Seriendiode (DS1; DS2) derart angeordnet ist, daß ein Stromfluß in der Hauptstromflußrichtung möglich ist, und zur jeweiligen Serienschaltung aus MOSFET-Schafter (T1; T2) und Seriendiode (DS1; DS2) eine Freilaufdiode (DF1; DF2) parallel geschattet ist, und
- einem Lastkreis (L; RL), der zumindest eine induktive Komponente (L) aufweist und mit dem Mittelpunkt der Halbbrückenanordnung verbunden ist,
**dadurch gekennzeichnet,**
**daß** parallel zu jeder Seriendiode (DS1; DS2) eine Entlastungskapazität (CE1; CE2) geschaltet ist.

2. Schaltungsanordnung nach Anspruch 1, **dadurch gekennzeichnet, daß** die jeweilige parasitäre Diode von der jeweiligen Body-Diode (DB1; DB2) und die jeweilige parasitäre Kapazität von der jeweiligen Ausgangskapazität (C_{OSS}1; C_{OSS}2) des MOSFET-Schalters (T1, T2) gebildet werden.

3. Schaltungsanordnung nach Anspruch 1, **dadurch gekennzeichnet, daß** jede Entlastungskapazität (CE1; CE2) derart dimensioniert ist, daß die im Betrieb der Schaltungsanordnung an der Entlastungskapazität (CE1; CE2) des jeweiligen im wesentlichen aus Entlastungskapazität (CE1; CE2) und parasitärer Kapazität (C_{OSS}1; C_{OSS}2) gebildeten Spannungsteilers abfallende Spannung stets kleiner als die Sperrspannung der jeweiligen Seriendiode (DS1; DS2) ist.

4. Schaltungsanordnung nach Anspruch 3, **dadurch gekennzeichnet, daß** die Entlastungskapazität (CE1; CE2) zwischen 100 pF und 10 nF beträgt.

5. Schaltungsanordnung nach Anspruch 1, **dadurch gekennzeichnet, daß** die Halbbrückenanordnung und zwei weitere MOSFET-Schalter eine Vollbrückenanordnung bilden, zwischen deren Mittelpunkten der Lastkreis (L; RL) angekoppelt ist.

6. Schaltungsanordnung nach Anspruch 1, **dadurch gekennzeichnet daß** die Halbbrückenanordnung und vier weitere MOSFET·Schalter eine Drei-Phasen-Brücke bilden, an die die Last angekoppelt ist.

7. Tiefsetzsteller mit einer Schaltungsanordnung nach einem der Ansprüche 1 bis 5.

8. Gleichstrommotor-Stromrichter mit einer Schaltungsanordnung nach einem der Ansprüche 1 bis 5.

9. Drei-Phasen-Motor-Stromrichter mit einer Schaltungsanordnung nach einem der Ansprüche 1 bis 6.

10. Vorschaltgerät zum Betrieb von Entladungslampen mit einem Tiefsetzsteller nach Anspruch 7.

## Claims

1. Circuit arrangement having
- a half-bridge arrangement comprising a first and a second MOSFET switch (T1;T2), each MOSFET switch (T1;T2) having, between its operating and reference electrodes, a parasitic diode, which is reverse-connected in parallel with the main current flow direction of the respective MOSFET switch (T1;T2), and also a parasitic capacitance, which is likewise connected between operating and reference electrodes, a series diode (DS1;DS2) being arranged in series with the respective MOSFET switch (T1;T2) in the main current flow direction in such a way that current can flow in the main current flow direction, and a freewheeling diode (DF1;DF2) being connected in parallel with the respective series circuit formed by the MOSFET switch (T1;T2) and the series diode (DS1;DS2), and
- a load circuit (L;RL), which has at least one inductive component (L) and is connected to the midpoint of the half-bridge arrangement,
**characterized in that** a load-relieving capacitance (CE1;CE2) is connected in parallel with each series diode (DS1;DS2).

2. Circuit arrangement according to Claim 1, **characterized in that** the respective parasitic diode is formed by the respective body diode (DB1;DB2) and the respective parasitic capacitance is formed by the respective output capacitance (C_{OSS}1;C_{OSS}2) of the MOSFET switch (T1, T2).

3. Circuit arrangement according to Claim 1, **characterized in that** each load-relieving capacitance (CE1;CE2) is dimensioned in such a way that the voltage dropped during operation of the circuit arrangement across the load-relieving capacitance (CE1;CE2) of the respective voltage divider essentially formed from the load-relieving capacitance (CE1;CE2) and the parasitic capacitance (C_{OSS}1;C_{OSS}2) is always smaller than the reverse voltage of the respective series diode (DS1;DS2).

4. Circuit arrangement according to Claim 3, **characterized in that** the load-relieving capacitance (CE1;CE2) is between 100 pF and 10 nF.

5. Circuit arrangement according to Claim 1, **characterized in that** the half-bridge arrangement and two further MOSFET switches form a full-bridge arrangement between whose midpoints the load circuit (L;RL) is coupled.

6. Circuit arrangement according to Claim 1, **characterized in that** the half-bridge arrangement and four further MOSFET switches form a three-phase bridge to which the load is coupled.

7. Step-down controller having a circuit arrangement according to one of Claims 1 to 5.

8. DC motor power converter having a circuit arrangement according to one of Claims 1 to 5.

9. Three-phase motor power converter having a circuit arrangement according to one of Claims 1 to 6.

10. Ballast for operating discharge lamps having a step-down controller according to Claim 7.

## Revendications

1. Montage comprenant
- un montage en demi pont comprenant un premier et un deuxième commutateurs ( T1 ; T2 ) MOSFET, chaque commutateur ( T1 ; T2 ) MOSFET ayant entre son électrode de travail et son électrode de référence une diode parasite montée anti-parallèlement au sens du flux du courant principal du commutateur ( T1 ; T2 ) MOSFET respectif, ainsi qu'une capacité parasite montée également entre l'électrode de travail et l'électrode de référence, une diode ( DS1 ; DS2 ) série étant montée séquentiellement au commutateur ( T1 ; T2 ) MOSFET respectif dans le sens du courant principal de façon à ce qu'un flux de courant soit possible dans le sens du flux du courant principal et une diode ( DF1 ; DF2 ) de roue libre étant montée en parallèle au circuit série respectif composé du commutateur ( T1 ; T2 ) MOSFET et de la diode ( DS1 ; DS2 ) série, et
- un circuit ( L ; RL ) de charge qui a au moins un composant ( L ) inductif et qui est relié au point médian du montage en demi pont,
**caractérisé**
**en ce qu'**une capacité ( CE1 ; CE2 ) d'équilibrage est montée en parallèle à chaque diode ( DS1 ; DS2 ) série.

2. Montage suivant la revendication 1, **caractérisé en ce que** la diode parasite respective est formée de la diode body ( DB1 ; DB2 ) respective et la capacité parasite respective est formée de la capacité ( C_{OSS}1 ; C_{OSS}2 ) de sortie respective du commutateur ( T1 ; T2 ) MOSFET.

3. Montage suivant la revendication 1, **caractérisé en ce que** chaque capacité ( CE1 ; CE2 ) d'équilibrage a des dimensions telles que la tension chutant, lorsque le montage fonctionne, aux bornes de la capacité ( CE1 ; CE2 ) d'équilibrage du diviseur respectif de tension formé essentiellement de la capacité ( CE1 ; CE2 ) d'équilibrage et de la capacité ( C_{OSS}1 ; C_{OSS}2 ) parasite, est toujours plus petite que la tension de blocage de la diode ( DS1 ; DS2 ) série respective.

4. Montage suivant la revendication 3, **caractérisé en ce que** la capacité ( CE1 ; CE2 ) d'équilibrage est comprise entre 100 pF et 10 nF.

5. Montage suivant la revendication 1, **caractérisé en ce que** le montage en demi-pont et deux autres commutateurs MOSFET forment un montage à pont complet entre les points médians du circuit ( L ; RL ) de charge.

6. Montage suivant la revendication 1, **caractérisé en ce que** le montage en demi-pont et quatre autres commutateurs MOSFET forment un pont à trois phases auquel la charge est couplée.

7. Circuit abaisseur de tension ayant un montage suivant l'une des revendications 1 à 5.

8. Convertisseur de moteur à courant continu ayant un montage suivant l'une des revendications 1 à 5.

9. Convertisseur de moteur triphasé ayant un montage suivant l'une des revendications 1 à 6.

10. Ballast pour faire fonctionner des lampes à décharge, ayant un circuit abaisseur de tension suivant la revendication 7.
